# FASCICULE DE BREVET EUROPEEN

(11) **EP 3 965 299 B1**
(45) Date de publication et mention de la délivrance du brevet: **25.03.2026**
(21) Numéro de dépôt: 21194691.8
(22) Date de dépôt: 03.09.2021
(51) Int. Cl.: H03K 17/30, H02M 1/36, H03K 17/725, H03K 17/74, H02M 1/08, H02M 7/06, H02M 7/12

(54) **DISPOSITIF DE COMMANDE D'UN THYRISTOR**
VORRICHTUNG ZUR STEUERUNG EINES THYRISTORS
DEVICE FOR CONTROLLING A THYRISTOR

(30) Priorité: 07.09.2020 FR 2009057
(43) Date de publication de la demande: 09.03.2022
(73) Titulaire: STMicroelectronics (Tours) SAS, 37100 Tours (FR)
(72) Inventeur: PICHON, Romain, 37380 Reugny (FR); HAGUE, Yannick, 37390 Mettray (FR)
(74) Mandataire: Cabinet Beaumont

(56) Documents cités:
- FR-A1- 2 735 296
- FR-A1- 2 746 981
- US-A- 3 735 158
- US-A- 4 158 121

## Description

### Domaine technique

La présente description concerne de façon générale les circuits électroniques, et plus particulièrement un dispositif électronique de commande d'un thyristor.

### Technique antérieure

Un thyristor, aussi appelé redresseur commandé au silicium ("Silicon Controlled Rectifier" en anglais) ou SCR, est constitué de quatre couches semiconductrices, généralement en silicium, alternativement dopées de type N et P.

Plus particulièrement, le thyristor comprend une première couche dopée de type P constituant l'anode du thyristor, une première couche dopée de type N reposant sur et en contact avec la première couche dopée de type P, une deuxième couche dopée de type P reposant sur et en contact avec la première couche dopée de type N, et une deuxième couche dopée de type N reposant sur et en contact avec la deuxième couche dopée de type P et constituant la cathode du thyristor. Lorsque la gâchette du thyristor correspond à la première couche dopée de type N, le thyristor est dit à gâchette d'anode. Lorsque la gâchette du thyristor correspond à la deuxième couche de type P, le thyristor est dit à gâchette de cathode.

Les thyristors à gâchette de cathode sont utilisés dans de nombreux dispositifs électroniques. Pour des raisons d'efficacité énergétique, ou, dit autrement, pour limiter la puissance consommée par un tel thyristor, il est souhaitable que le déclenchement, c'est-à-dire le passage commandé à l'état passant, d'un thyristor à gâchette de cathode se fasse dans son premier quadrant. Dans le premier quadrant, le thyristor est commuté à l'état passant en fournissant un courant positif à sa gâchette, ce courant allant de la gâchette vers la cathode, alors que la tension V_{AK} entre l'anode et la cathode du thyristor est positive et supérieure à une tension de seuil de thyristor, la tension V_{AK} étant référencée par rapport à la cathode du thyristor. Le document US 3 735 158 A décrit un réseau de commutation à conduction bidirectionnelle et à trois bornes, comprenant des thyristors.

On connait des dispositifs électroniques de commande d'un thyristor configurés pour fournir un signal ou courant de commande à la gâchette d'un thyristor. Ces dispositifs de commande sont configurés pour recevoir un premier signal de commande et pour générer un deuxième signal de commande fourni à la gâchette du thyristor. Dit autrement, ces dispositifs sont configurés pour mettre en forme un signal de commande fourni à la gâchette du thyristor. De tels circuits de commande sont aussi appelés dispositifs de commande rapprochée ("driver" en anglais).

Les dispositifs connus de commande d'un thyristor, et en particulier d'un thyristor à gâchette de cathode, souffrent de divers inconvénients.

### Résumé de l'invention

Il existe un besoin de pallier tout ou partie des inconvénients des dispositifs connus de commande d'un thyristor, notamment d'un thyristor à gâchette de cathode.

Un mode de réalisation pallie tout ou partie des inconvénients des dispositifs connus de commande d'un thyristor.

Un mode de réalisation prévoit un dispositif de commande comprenant un triac et une première diode connectés en série entre une première borne du dispositif configurée pour être connectée à une gâchette de cathode d'un thyristor, et une deuxième borne du dispositif configurée pour être connectée à une anode du thyristor, le triac ayant une gâchette connectée à une troisième borne du dispositif configurée pour recevoir un signal de commande, dans lequel la première diode a une cathode reliée à la première borne du dispositif.

Selon un mode de réalisation, la cathode de la première diode est connectée à la première borne du dispositif, le dispositif comprenant en outre :
une quatrième borne configurée pour être connectée à une gâchette de cathode d'un autre thyristor ; et
une deuxième diode, de préférence identique à la première diode, connectée en série avec le triac entre les deuxième et quatrième bornes du dispositif, la cathode de la deuxième diode étant connectée à la quatrième borne du dispositif et la deuxième borne du dispositif étant en outre configurée pour être connectée à une anode dudit autre thyristor.

Selon un mode de réalisation, le dispositif comprend en outre un circuit configuré pour fournir le signal de commande à la troisième borne du dispositif, le circuit étant connecté à la deuxième borne du dispositif et étant configuré pour être alimenté électriquement par un potentiel d'alimentation, de préférence positif, référencé à la deuxième borne du dispositif.

Un autre mode de réalisation prévoit un circuit intégré comprenant un dispositif tel que défini ci-dessus.

Un autre mode de réalisation prévoit un pont redresseur comprenant :
une première branche et une deuxième branche connectées en parallèle entre un premier noeud interne du pont relié, de préférence connecté, à un premier noeud de sortie du pont, et un deuxième noeud interne du pont ;
une résistance et un thyristor connectés en parallèle entre le deuxième noeud interne et un deuxième noeud de sortie du pont, l'anode du thyristor étant connectée au deuxième noeud de sortie ; et
un dispositif tel que défini ci-dessus, la deuxième borne du dispositif étant connectée au deuxième noeud de sortie et la première borne du dispositif étant connectée la gâchette de cathode du thyristor.

Selon un mode de réalisation, le pont redresseur comprenant en outre un circuit configuré pour fournir un signal de commande à la troisième borne du dispositif, le circuit étant connecté au deuxième noeud de sortie du pont et étant configuré pour être alimenté électriquement par un potentiel d'alimentation, de préférence positif, référencé au deuxième noeud de sortie du pont.

Selon un mode de réalisation, le pont redresseur comprend :
un dispositif tel que défini ci-dessus, la deuxième borne du dispositif étant connectée à un premier noeud interne du pont relié, de préférence connecté, à un premier noeud de sortie du pont ;
un premier thyristor comprenant une cathode connectée à un premier noeud d'entrée du pont, une anode connectée au premier noeud interne, et une gâchette de cathode connectée à la première borne du dispositif ; et
un deuxième thyristor comprenant une cathode connectée à un deuxième noeud d'entrée du pont, une anode connectée au premier noeud interne, et une gâchette de cathode connectée à la quatrième borne du dispositif.

Selon un mode de réalisation, le pont redresseur comprend en outre un circuit configuré pour fournir un signal de commande à la troisième borne du dispositif, le circuit étant connecté au premier noeud interne du pont et étant configuré pour être alimenté électriquement par un potentiel d'alimentation, de préférence positif, référencé au premier noeud interne du pont.

Selon un mode de réalisation, le pont redresseur comprenant en outre :
une diode comprenant une cathode connectée à un deuxième noeud interne du pont relié, de préférence connecté, à un deuxième noeud de sortie du pont, et une anode connectée au premier noeud d'entrée du pont ;
une autre diode comprenant une cathode connectée au deuxième noeud interne du pont et une anode connectée au deuxième noeud d'entrée du pont.

Un autre mode de réalisation prévoit un circuit intégré comprenant un pont redresseur tel que défini ci-dessus.

Un autre mode de réalisation prévoit un contacteur statique comprenant :
un premier thyristor et un deuxième thyristor connectés en antiparallèle entre une première borne du contacteur et une deuxième borne du contacteur, une anode du premier thyristor étant connectée à la première borne du contacteur ; et
un dispositif tel que défini ci-dessus, la première borne du dispositif étant connectée à une gâchette de cathode du premier thyristor et la deuxième borne du dispositif étant connectée à la première borne du contacteur.

Selon un mode de réalisation, le contacteur comprend en outre un circuit configuré pour fournir un signal de commande à la troisième borne du dispositif, le circuit étant connecté à la première borne du contacteur et étant configuré pour être alimenté électriquement par un potentiel d'alimentation, de préférence positif, référencé à la première borne du contacteur.

Selon un mode de réalisation, le circuit est en outre configuré pour fournir un autre signal de commande à la gâchette du deuxième thyristor, de préférence, une borne du circuit configurée pour fournir ledit autre signal de commande étant connectée à la gâchette du deuxième thyristor ou étant reliée à la gâchette du deuxième thyristor par une diode.

Un autre mode de réalisation prévoit un circuit intégré comprenant un contacteur tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme d'un circuit, un mode de réalisation d'un pont redresseur de tension comprenant un dispositif de commande d'un thyristor selon un mode de réalisation ;
la figure 2 représente, sous la forme d'un circuit, un autre mode de réalisation d'un pont redresseur de tension comprenant un dispositif de commande d'un thyristor selon un autre mode de réalisation ; et
la figure 3 représente, sous la forme d'un circuit, un mode de réalisation d'un contacteur statique comprenant le dispositif de commande de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les divers dispositifs électroniques usuels comprenant au moins un thyristor, et plus particulièrement au moins un thyristor à gâchette de cathode, n'ont pas tous été décrits, les modes de réalisation et variantes de circuits de commande décrits étant compatibles avec ces dispositifs électroniques usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

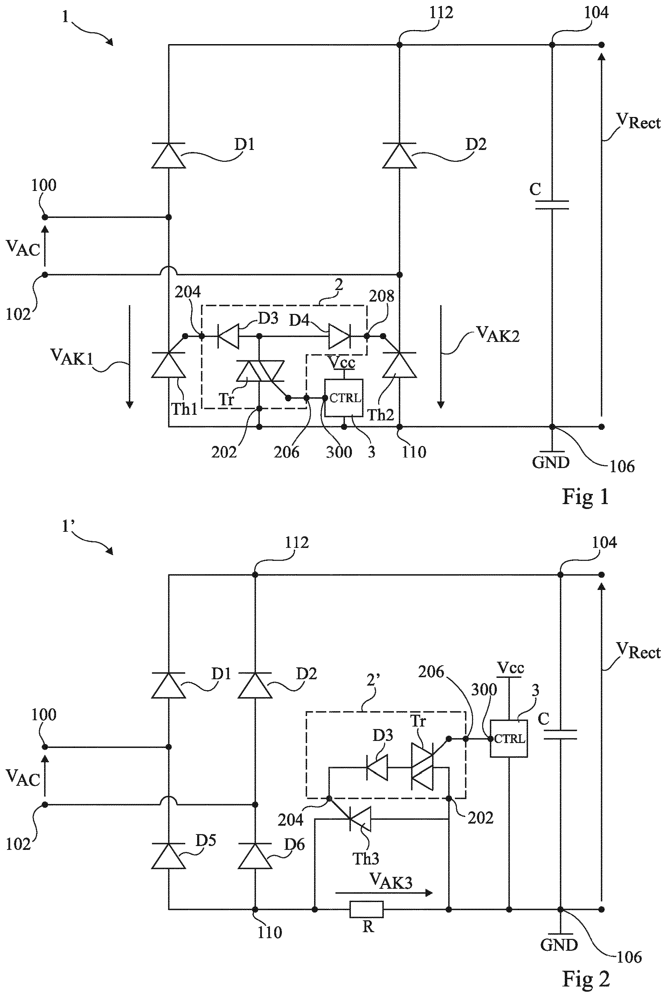

La figure 1 représente, sous la forme d'un circuit, un mode de réalisation d'un pont redresseur de tension 1 comprenant un dispositif 2 de commande d'un thyristor selon un mode de réalisation.

Le pont redresseur 1 comprend deux noeuds d'entrée 100 et 102. Le pont redresseur 1 comprend en outre deux noeuds de sortie 104 et 106. Le pont 1 comprend également deux noeuds internes 110 et 112 reliés aux noeuds respectifs 106 et 104. Plus particulièrement, dans cet exemple, les noeuds 110 et 112 sont connectés aux noeuds respectifs 106 et 104, ou, dit autrement, le noeud 110 est confondu avec le noeud 106 et le noeud 112 est confondu avec le noeud 104.

Le pont redresseur 1 comprend un thyristor Th1 à gâchette de cathode, connecté entre les noeuds 100 et 110. Plus particulièrement, l'anode du thyristor Th1 est connectée au noeud 100 et la cathode du thyristor Th1 est connectée au noeud 110.

Le pont redresseur 1 comprend un thyristor Th2 à gâchette de cathode, connecté entre les noeuds 102 et 110. Plus particulièrement, l'anode du thyristor Th2 est connectée au noeud 102 et la cathode du thyristor Th2 est connectée au noeud 110.

Les thyristors Th1 et Th2 constituent un demi pont du pont redresseur 1, et plus particulièrement un demi pont inférieur du pont 1.

Dans cet exemple, le pont redresseur 1 comprend en outre une diode D1 et une diode D2.

La diode D1 est connectée entre les noeuds 100 et 112. Plus particulièrement, l'anode de la diode D1 est connectée au noeud 100 et la cathode de la diode D1 est connectée au noeud 112. La diode D1 est donc connectée en série avec le thyristor Th1, entre les noeuds 110 et 112. La diode D1 et le thyristor Th1 appartiennent à une même première branche du pont redresseur 1 reliant les noeuds 110 et 112 entre eux.

La diode D2 est connectée entre les noeuds 102 et 112. Plus particulièrement, l'anode de la diode D2 est connectée au noeud 102 et la cathode de la diode D2 est connectée au noeud 112. La diode D2 est donc connectée en série avec le thyristor Th2, entre les noeuds 110 et 112. La diode D2 et le thyristor Th2 appartiennent à une même deuxième branche du pont redresseur 1 reliant les noeuds 110 et 112 entre eux.

Les diodes D1 et D2 constituent un autre demi pont du pont redresseur 1, et plus particulièrement un demi pont supérieur du pont 1.

Le pont redresseur 1 est configuré pour redresser une tension alternative V_{AC} appliquée entre ces noeuds d'entrée 100 et 102. Le pont redresseur 1 est configuré pour fournir une tension redressée V_{Rect} entre ses noeuds de sortie 104 et 106.

En pratique, les deux noeuds de sortie 104 et 106 sont connectés à deux bornes d'alimentation d'un dispositif électronique. Le noeud 106 est alors à un potentiel de référence GND du dispositif électronique alimenté par la tension V_{Rect}.

Une capacité C est de préférence connectée entre les noeuds 104 et 106 du pont redresseur 1. La capacité C peut faire partie du pont redresseur 1 ou être extérieure au pont redresseur 1.

Le dispositif 2 est le dispositif de commande du thyristor Th1, c'est-à-dire qu'il est configuré pour commander le thyristor Th1. Plus exactement, le dispositif 2 est configuré pour recevoir un signal de commande, et pour générer un autre signal de commande à partir du signal de commande reçu, le signal de commande généré par le dispositif 2 étant fourni à la gâchette de cathode du thyristor Th1. Dit autrement, le dispositif 2 est le dispositif de commande rapprochée du thyristor Th1.

Le dispositif 2 comprend une borne 202 configurée pour être connectée à l'anode du thyristor Th1, la borne 202 étant connectée à l'anode du thyristor Th1 en figure 1. Le dispositif 2 comprend une borne 204 configurée pour être connectée à la gâchette de cathode du thyristor Th1, la borne 204 étant connectée à la gâchette de cathode du thyristor Th1 en figure 1. Le dispositif 2 comprend une borne 206 configurée pour recevoir un signal de commande.

Le dispositif 2 comprend un triac Tr et une diode D3 connectés en série entre les bornes 204 et 202 du dispositif 2.

La diode D3 est configurée pour empêcher la circulation d'un courant positif depuis la borne 202 vers la borne 204 lorsque la diode D3 est polarisée en inverse, c'est-à-dire lorsque son potentiel d'anode est inférieur à son potentiel de cathode. En outre, la diode D3 est configurée pour laisser passer un courant positif depuis la borne 202 vers la borne 204 lorsqu'elle est polarisée en direct, et pour empêcher la circulation d'un courant positif depuis la borne la borne 204 vers la borne 202. Dit autrement, la diode D3 a sa cathode reliée à la borne 204, et son anode reliée à la borne 202.

Plus particulièrement, dans ce mode de réalisation, la cathode de la diode D3 est connectée à la borne 204 et l'anode de la diode D3 est connectée à une première borne de conduction du triac Tr, une deuxième borne de conduction du triac Tr étant connectée à la borne 202. En outre, la gâchette du triac Tr est connectée à la borne 206 du dispositif 2.

Dans ce mode de réalisation, le dispositif 2 est également le dispositif de commande du thyristor Th2, c'est-à-dire qu'il est aussi configuré pour commander le thyristor Th2. Plus exactement, le dispositif 2 est configuré pour fournir un signal de commande à la gâchette de cathode du thyristor Th2, le signal de commande fourni étant généré par le dispositif 2 à partir du signal de commande reçu sur sa borne 206. Dit autrement, le dispositif 2 est le dispositif de commande rapprochée du thyristor Th2.

Le dispositif 2 comprend alors une borne supplémentaire 208 configurée pour être connectée à la gâchette de cathode du thyristor Th2, la borne 208 étant connectée à la gâchette de cathode du thyristor Th2 en figure 1. Le dispositif 2 comprend en outre une diode D4, de préférence identique à la diode D3. La diode D4 est configurée pour empêcher la circulation d'un courant positif depuis la borne 202 vers la borne 208 lorsque la diode D4 est polarisée en inverse. En outre, la diode D4 est configurée pour laisser passer un courant positif depuis la borne 202 vers la borne 208 lorsqu'elle est polarisée en direct, et pour empêcher la circulation d'un courant positif depuis la borne la borne 208 vers la borne 202. Dit autrement, la diode D4 a sa cathode reliée à la borne 208, et son anode reliée à la borne 202.

Plus particulièrement, dans ce mode de réalisation, la diode D4 est connectée en série avec le triac Tr. La cathode de la diode D4 est alors connectée à la borne 208 et l'anode de la diode D4 est connectée à la première borne de conduction du triac Tr.

En figure 1, la borne 206 du dispositif 2 est connectée à une borne 300 d'un circuit de commande 3 (bloc CTRL). Le circuit 3 est par exemple un microcontrôleur, la borne 300 étant une borne de sortie du microcontrôleur. Le circuit 3 est configuré pour fournir un signal de commande à la borne 206 du dispositif 2.

Le circuit 3 est connecté à la borne 202 du dispositif 2, c'est-à-dire à l'anode du thyristor Th1. En effet, le circuit 3 est configuré pour être alimenté électriquement par un potentiel d'alimentation Vcc, positif et référencé par rapport au potentiel de la borne 202. Ainsi, le circuit 3 est connecté à un noeud d'application du potentiel Vcc. A titre d'exemple, le potentiel Vcc est obtenu à partir de la tension V_{Rect} au moyen d'un circuit de conversion de tension tel que, par exemple, un convertisseur de tension abaisseur ou un convertisseur de tension capacitif, le circuit de conversion de tension ayant une borne reliée à la borne 202.

Le circuit 3 peut faire partie du dispositif 2 ou être extérieur au dispositif 2. Plus généralement, le circuit 3 peut faire partie du pont redresseur 1 ou être extérieur au pont redresseur 1.

En fonctionnement, lorsque la tension V_{AC} est telle que le potentiel du noeud 100 est supérieur à celui du noeud 102, les diodes D1 et D2 sont respectivement passante et bloquée. En outre, la tension V_{AK2} entre l'anode et la cathode du thyristor Th2 est positive et la tension V_{AK1} entre l'anode et la cathode du thyristor Th1 est négative, le thyristor Th1 étant alors bloqué. Lorsque le circuit 3 fournit un signal de commande à la borne 206, c'est-à-dire lorsqu'un courant de déclenchement, dans cet exemple positif, est fourni à la gâchette du triac Tr, le triac devient passant. A titre d'exemple, pour fournir le courant de déclenchement, la borne 300 du circuit 3 fournit une impulsion de tension positive et référencée à la borne 202, cette impulsion en tension étant transformée en une impulsion de courant par une résistance (non représentée) reliant la borne 300 à la borne 206. Le passage du triac Tr à l'état passant résulte en un courant positif circulant dans le triac Tr, depuis la borne 202 en direction des bornes 204 et 208. Comme le potentiel du noeud 100 est supérieur au potentiel du noeud 102, la diode D3 est polarisée en inverse et est bloquée. Le courant circulant dans le triac Tr circule alors dans la diode D4 polarisée en direct, jusqu'à la borne 208. Ce courant positif est donc fourni à la gâchette de cathode du thyristor Th2 qui commute à l'état passant.

Lorsque le potentiel du noeud 100 diminue et se rapproche du potentiel du noeud 102 jusqu'à devenir égal au potentiel du noeud 102, du fait que la tension entre les noeuds 100 et 102 s'annule, le thyristor Th2 et le triac Tr commutent à l'état bloqué.

Pour simplifier la description du fonctionnement du pont 1 et du dispositif 2 faite ci-dessus, les tensions de seuil des diodes, des thyristors et du triac ont été négligées. La personne du métier est en mesure de déduire le fonctionnement du pont 1 et du dispositif 2 lorsque ces tensions de seuils sont prises en comptes.

En outre, la personne du métier est en mesure de déterminer le fonctionnement du pont 1 et du dispositif 2 dans le cas où le potentiel du noeud 102 est supérieur à celui du noeud 100, ce fonctionnement étant symétrique à celui décrit ci-dessus dans le cas où le potentiel du noeud 100 est supérieur à celui du noeud 102. En particulier, dans le cas où le potentiel du noeud 102 est supérieur à celui du noeud 100, la diode D4 est polarisé en inverse et le thyristor Th2 est bloqué du fait que sa tension V_{AK2} est négative. Ainsi, lorsque le signal de commande fourni par le circuit 3 est reçu par la borne 206 du dispositif 2 et que le triac Tr commute à l'état passant, le courant positif qui circule à travers le triac Tr depuis la borne 202 est fourni à la gâchette de cathode du thyristor Th1 qui commute à l'état passant du fait que sa tension V_{AK1} est positive.

La personne du métier est également en mesure de choisir les diodes D3 et D4 pour qu'elles aient une tenue en tension suffisante par rapport à l'amplitude de la tension V_{AC} et/ou à d'éventuelles surtensions entre les noeuds 100 et 102, ces surtensions résultant par exemple d'une décharge électrostatique entre les noeuds 100 et 102.

Un avantage du dispositif 2 est que la commutation du thyristor Th1, respectivement Th2, est mise en œuvre dans le premier quadrant de fonctionnement du thyristor Th1, respectivement Th2.

Un avantage du dispositif 2 est que, lorsque le thyristor Th1, respectivement Th2, est bloqué car sa tension V_{AK1}, respectivement V_{AK2}, est négative, du fait que la diode D3, respectivement D4, est bloquée (polarisée en inverse), le courant de fuite circulant par la gâchette de cathode du thyristor Th1, respectivement Th2, est beaucoup plus faible, par exemple au moins 10 ou 100 fois plus faible, que le courant de fuite qui aurait pu y circuler en l'absence de la diode D3, respectivement D4, ce courant de fuite étant alors par exemple de l'ordre de 100 µA.

Un avantage du dispositif 2 est que le circuit 3 n'a pas besoin de connaître la polarité de la tension V_{AC}, c'est-à-dire si le potentiel du noeud 100 est supérieur ou bien inférieur à celui du noeud 102. En effet, il suffit que le circuit 3 détecte chaque annulation de la tension V_{AC}. Après chaque annulation détectée, le circuit 3 fournit alors un signal de commande à la borne 206 du dispositif 2 et seul le bon thyristor Th1 ou Th2, c'est-à-dire le thyristor Th1 ou Th2 ayant une tension respectivement V_{AK1} ou V_{AK2} positive, commute à l'état passant.

Un avantage du dispositif 2 est que les thyristors Th1 et Th2 ne peuvent pas être passant simultanément, du fait que le circuit 3 ne fournit qu'un seul signal de commande.

Un avantage du dispositif 2 est que le circuit de commande 3 ne fournit qu'un seul signal de commande pour commander les deux thyristors Th1 et Th2, ce qui permet de n'utiliser qu'une borne de sortie du circuit 3, par exemple un microcontrôleur.

Un avantage du dispositif 2 est qu'il permet d'utiliser un circuit de commande 3 dont l'alimentation positive Vcc peut être obtenue sans utiliser de pompe de charge ou d'optocoupleurs.

Un avantage du dispositif 2 est qu'il est entièrement réalisable sous la forme d'un circuit intégré, et, plus généralement, qu'il permet de réaliser le pont 1 entièrement sous la forme d'un circuit intégré.

Un avantage du dispositif 2 est que le triac Tr peut être dimensionné de sorte qu'un courant positif appliqué sur sa gâchette ayant une valeur relativement faible, par exemple inférieure ou égale à environ 0,1 A, voire à 10 mA, est suffisant pour le déclencher. Cela permet par exemple que le circuit 3 soit mis en œuvre au moyen d'un microcontrôleur sachant qu'un microcontrôleur ne peut fournir qu'un courant ayant une valeur relativement faible.

Un avantage du dispositif 2 est que les tensions de seuil des diodes D3 et D4 et du triac Tr ont une influence sur la partie de commande des thyristors Th1 et Th2, mais pas sur la partie de puissance des thyristors Th1 et Th2. Dit autrement, le dispositif 2 permet d'éviter de recourir, en plus des composants à seuil Th1, Th2, D1 et D2, à un composant à seuil qui serait connecté en série avec le thyristor Th1 dans la branche du pont 1 comprenant le thyristor Th1 ou avec le thyristor Th2 dans la branche du pont 1 comprenant le thyristor Th2, ce qui aurait diminué le rendement du pont 1.

On aurait pu penser à inverser la position de la diode D1, respectivement D2, avec celle du thyristor Th1, respectivement Th2. Toutefois, pour fournir un courant de déclenchement positif à la gâchette de l'un ou l'autre des thyristor Th1 et Th2 de manière à déclencher ces thyristors dans leur premier quadrant, il aurait alors fallu prévoir une source d'alimentation isolée, par exemple par un transformateur d'isolation ou par un optocoupleur, fournissant un potentiel positif référencé par rapport au noeud 112 du pont 1.

On aurait également pu penser à remplacer les thyristors Th1 et Th2 à gâchette de cathode par des thyristors à gâchette d'anode commandés de manière à être déclenchés dans leur premier quadrant. Toutefois, il n'est pas possible de réaliser de manière intégrée de tels thyristors à gâchette d'anode à déclenchement dans le premier quadrant, alors que, selon un mode de réalisation, le pont 1 fait partie d'un circuit intégré.

En outre, le remplacement des thyristors Th1 et Th2 à gâchette de cathode par des thyristors à gâchette d'anode commandés de manière à être déclenchés dans leur premier quadrant aurait nécessité de prévoir une source d'un potentiel négatif référencé par rapport à l'anode de ces thyristors à gâchette d'anode, ce qui n'est pas souhaitable.

On a décrit un mode de réalisation du dispositif 2 permettant de commander les deux thyristors Th1 et Th2 du pont 1. Dans une variante de réalisation non illustrée, le dispositif 2 comprend un triac Tr' supplémentaire dont la gâchette est connectée à la borne 206 du dispositif 2, et la diode D4 est connectée en série, entre les bornes 202 et 208, avec ce triac Tr' plutôt qu'avec le triac Tr. Dans une telle variante, il est possible d'inverser la position de la diode D3, respectivement D4, et celle du triac Tr, respectivement Tr', qui sont connectés en série entre les bornes 202 et 206, respectivement 202 et 208.

La figure 2 représente, sous la forme d'un circuit, un autre mode de réalisation d'un pont redresseur de tension 1' comprenant un dispositif 2' de commande d'un thyristor selon un autre mode de réalisation.

Seules les différences entre le pont 1 et le pont 1' et les différences entre le dispositif 2 et 2' sont ici mises en exergue.

Le pont 1' comprend, comme le pont 1, deux branches connectées en parallèle entre les noeuds 110 et 112.

Toutefois, dans cet exemple, dans la première branche du pont 1', le thyristor Th1 est remplacé par une diode D5, la diode D1 étant alors en série avec la diode D5. Plus particulièrement la cathode de la diode D5 est connectée au noeud 100 et l'anode de la diode D5 est connectée au noeud 110. De manière similaire, dans la deuxième branche du pont 1', le thyristor Th2 est remplacé par une diode D6, la diode D2 étant alors en série avec la diode D6. Plus particulièrement la cathode de la diode D6 est connectée au noeud 102 et l'anode de la diode D6 est connectée au noeud 110.

Le pont 1' diffère du pont 1 également en ce que le noeud 110 n'est pas connecté au noeud 106. En effet, dans ce mode de réalisation, le pont 1' comprend une résistance R connectée en parallèle avec un thyristor Th3 à gâchette de cathode, entre les noeuds 110 et 106. L'anode du thyristor Th3 est connectée au noeud 106, la cathode du thyristor Th3 étant connectée au noeud 110.

Le pont 1' comprend le dispositif 2' de commande du thyristor Th3, c'est-à-dire que le dispositif 2' est configuré pour commander le thyristor Th3. Plus exactement, le dispositif 2' est configuré pour recevoir un signal de commande, et pour générer un autre signal de commande à partir du signal de commande reçu, le signal de commande généré par le dispositif 2' étant fourni à la gâchette de cathode du thyristor Th3. Dit autrement, le dispositif 2' est le dispositif de commande rapprochée du thyristor Th3.

Le dispositif 2' diffère du dispositif 2 (figure 1) en ce qu'il ne comprend pas la diode D4, ni la borne 208. En effet, dans ce mode de réalisation, le dispositif 2' ne commande qu'un seul thyristor Th3, contrairement au dispositif 2 qui commande deux thyristors Th1 et Th2.

Ainsi, comme le dispositif 2, le dispositif 2' comprend :
la borne 202 configurée pour être connectée à l'anode du thyristor Th3, la borne 202 étant connectée à l'anode du thyristor Th3 en figure 2 ;
la borne 204 configurée pour être connectée à la gâchette de cathode du thyristor Th3, la borne 204 étant connectée à la gâchette de cathode du thyristor Th3 en figure 2 ; et
la borne 206 configurée pour recevoir un signal de commande.

Le dispositif 2' comprend le triac Tr et la diode D3 connectés en série entre les bornes 204 et 202 du dispositif 2, la gâchette du triac Tr étant connectée à la borne 206 du dispositif 2. La diode D3 est configurée pour assurer la même fonction que dans le dispositif 2.

Dans cet exemple, la cathode de la diode D3 est connectée à la borne 204 et l'anode de la diode D3 est connectée à une première borne de conduction du triac Tr, une deuxième borne de conduction du triac Tr étant connectée à la borne 202. Dans un autre exemple non illustré, l'anode de la diode D3 est connectée à la borne 202, et le triac Tr est connecté entre la cathode de la diode D3 et la borne 204. Dans cet autre exemple, le triac Tr est alors un triac pouvant être déclencher dans ses quatre quadrants de fonctionnement.

Comme en figure 1, la borne 206 du dispositif 2' est connectée à la borne 300 du circuit 3, configuré pour fournir le signal de commande à la borne 206 du dispositif 2. En outre, le circuit 3 est connecté à la borne 202 du dispositif 2', c'est-à-dire à l'anode du thyristor Th3, et est configuré pour être alimenté électriquement par le potentiel d'alimentation Vcc référencé par rapport au potentiel de la borne 202.

Le circuit 3 peut faire partie du dispositif 2' ou être extérieur au dispositif 2', et, plus généralement, le circuit 3 peut faire partie du pont redresseur 1' ou être extérieur au pont redresseur 1'.

La connexion en parallèle du thyristor Th3 et de la résistance R forme un circuit de contournement ("bypass" en anglais). Ce circuit permet, lorsque la capacité C est déchargée, de limiter le courant d'appel ("inrush current" en anglais) en laissant le thyristor Th3 à l'état bloqué. Ainsi, la charge de la capacité s'effectue avec la constante de temps Rv*Cv, où Rv et Cv représentent les valeurs des composants respectifs R et C. Une fois la capacité C suffisamment chargée, le thyristor Th3 est commuté à l'état passant pour éviter d'éventuels phénomènes de surchauffe de la résistance R entraînant une modification du pont 1' et une baisse de son rendement. Comme le potentiel du noeud 106 est supérieur au potentiel du noeud 110, c'est-à-dire que la tension V_{AK3} du thyristor Th3 est positive, la commutation du thyristor Th3 à l'état passant résulte de la fourniture, par le circuit 3, d'un signal de commande à la borne 206 du dispositif 2', par exemple une impulsion d'un potentiel positif référencé par rapport à la borne 202. La fourniture du signal de commande à la borne 206 entraîne la mise en conduction du triac Tr et la fourniture d'un courant positif à la gâchette de cathode du thyristor Th3 par le dispositif 2'.

Selon un mode de réalisation, le dispositif 2', voire l'ensemble du pont 1', fait partie d'un circuit intégré.

Le dispositif 2' bénéficie des mêmes avantages que ceux dont bénéficie le dispositif 2, à l'exception des avantages liés à la commande de deux thyristors simultanément.

Les modes de réalisation des figures 1 et 2 peuvent être combinés, c'est-à-dire qu'on peut prévoir un pont redresseur comprenant non seulement les thyristors Th1 et Th2 avec leur dispositif de commande 2, mais aussi la résistance R en parallèle du thyristor Th3 commandé par le dispositif 2'.

Par ailleurs, l'ensemble du circuit de contournement et du dispositif de commande 2' peut être associé à d'autres circuits qu'un pont redresseur, pour limiter le courant d'appel d'une capacité.

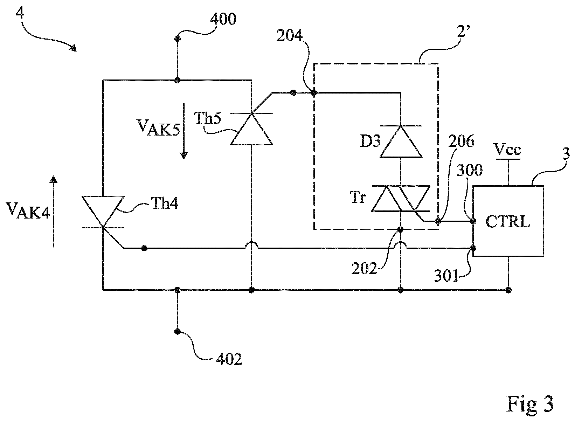

La figure 3 représente, sous la forme d'un circuit, un mode de réalisation d'un contacteur statique 4 ("Solid State Relay" en anglais) comprenant le dispositif 2' de la figure 2.

Le contacteur 4 comprend deux bornes 400 et 402, et deux thyristors Th4 et Th5 à gâchette de cathode, connectés en antiparallèle entre les bornes 400 et 402. Dans cet exemple, l'anode du thyristor Th4 est reliée, de préférence connectée, à la borne 400, la cathode du thyristor Th4 étant reliée, de préférence connectée, à la borne 402, et, de manière symétrique, l'anode du thyristor Th5 est reliée, de préférence connectée, à la borne 402, la cathode du thyristor Th4 étant reliée, de préférence connectée, à la borne 400.

Le contacteur 4 comprend le dispositif 2' décrit en relation avec la figure 2. La borne 204 est connectée à la gâchette du thyristor Th5, la borne 202 étant connectée à l'anode du thyristor Th5, c'est-à-dire à la borne 402 dans l'exemple de la figure 3.

Le contacteur 4 comprend également le circuit 3 dont la borne 300 est connectée à la borne 206 pour fournir le signal de commande au dispositif 2'. En outre, le circuit 3 est connecté à la borne 202 du dispositif 2', c'est-à-dire à l'anode du thyristor Th5, et est configuré pour être alimenté électriquement par le potentiel d'alimentation Vcc référencé par rapport au potentiel de la borne 202. A titre d'exemple, le potentiel Vcc est fourni par une alimentation à découpage comprenant une isolation galvanique entre son entrée et sa sortie, une telle alimentation étant couramment appelée alimentation à retour rapide ("flyback" en anglais). Selon un autre exemple, le contacteur 4 appartient à un dispositif électronique comprenant un circuit de correction de facteur de puissance ("Power Factor Correction") ou circuit PFC, le potentiel Vcc est généré à partir d'un enroulement supplémentaire de l'inductance du circuit PFC.

Selon un mode de réalisation, le circuit 3 est en outre configuré pour fournir un signal de commande au thyristor Th4. Le circuit 3 comprend alors une borne 301 reliée, de préférence connectée, à la gâchette de cathode du thyristor Th4.

De préférence, la borne 301 est reliée à la gâchette du thyristor Th4 par une diode (non représentée) configurée pour qu'un courant positif ne circule pas de la borne 301 vers la gâchette du thyristor quand cette diode est polarisée en inverse, c'est-à-dire quand la tension V_{AK4} du thyristor Th4 est négative. Cette diode a alors son anode connectée à la borne 301 du circuit 3. Cette diode permet de limiter les fuites de courant, via la gâchette du thyristor Th4, lorsque la tension V_{AK4} est négative.

Le circuit 3 peut faire partie du dispositif 2' ou être extérieur au dispositif 2', et, plus généralement, le circuit 3 peut faire partie du contacteur 4 ou être extérieur au redresseur 4.

Selon un mode de réalisation, le contacteur 4 fait partie d'un circuit intégré.

Le fonctionnement du contacteur 4 est le suivant. Lorsque le potentiel de la borne 402 est supérieur à celui de la borne 400, la tension V_{AK5} du thyristor Th5 est positive et la tension V_{AK4} du thyristor Th4 est négative, le thyristor Th4 étant bloqué. Si le circuit 3 fournit un signal de commande à la borne 206 du dispositif 2', le triac Tr se déclenche et un courant positif est fourni à la gâchette du thyristor Th5 qui se déclenche à son tour. Lorsque le potentiel de la borne 402 est inférieur à celui de la borne 400, la tension V_{AK4} du thyristor Th4 est positive et la tension V_{AK5} du thyristor Th5 est négative, le thyristor Th5 étant bloqué. Si le circuit 3 fournit un signal de commande à la gâchette du thyristor Th4, le thyristor Th4 se déclenche.

Bien que le dispositif 2' soit utilisé pour commander le thyristor Th5 du contacteur 4, et non pas un thyristor d'un pont redresseur de tension comme par exemple le thyristor Th3 du circuit de contournement décrit en relation avec la figure 2, il bénéficie des mêmes avantages que ceux dont bénéficie le dispositif 2.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est en mesure de remplacer les diodes D1 et D2 du pont 1 par d'autres composants à seuil tels que des transistors, des thyristors ou des triacs. De la même manière, la personne du métier est en mesure remplacer les diodes D1 et D2 et/ou les diodes D5 et D6 du pont 1' par d'autres composants à seuil tels que des transistors, des thyristors ou des triacs.

Par ailleurs, l'utilisation d'un dispositif 2 ou 2' pour commander un thyristor ne se limite pas au cas où ce thyristor appartient à un demi pont inférieur d'un pont redresseur de tension, à un circuit de contournement d'un pont redresseur de tension ou à un contacteur statique.

Enfin, la mise en oeuvre pratique des modes de réalisation et variantes décrits est à la portée de la personne du métier à partir des indications fonctionnelles données ci-dessus. En particulier, la personne du métier est en mesure de choisir des diodes D3 et D4 et/ou du triac Tr, notamment en fonction de leurs tensions de seuil et/ou de leur tenue en tension.

## Revendications

1. Dispositif (2 ; 2') de commande comprenant un triac (Tr) et une première diode (D3) connectés en série entre une première borne (204) du dispositif (2 ; 2') configurée pour être connectée à une gâchette de cathode d'un thyristor (Th1 ; Th3 ; Th5), et une deuxième borne (202) du dispositif (2 ; 2') configurée pour être connectée à une anode du thyristor (Th1 ; Th3 ; Th5), le triac (Tr) ayant une gâchette connectée à une troisième borne (206) du dispositif (2 ; 2') configurée pour recevoir un signal de commande, **caractérisé en ce que** la première diode (D3) a une cathode reliée à la première borne (204) du dispositif (2 ; 2').

2. Dispositif (2) selon la revendication 1, dans lequel la cathode de la première diode (D3) est connectée à la première borne (204) du dispositif (2), le dispositif (2) comprenant en outre :
une quatrième borne (208) configurée pour être connectée à une gâchette de cathode d'un autre thyristor (Th2) ; et
une deuxième diode (D4), de préférence identique à la première diode (D3), connectée en série avec le triac (Tr) entre les deuxième (202) et quatrième (208) bornes du dispositif, la cathode de la deuxième diode (D4) étant connectée à la quatrième borne (208) du dispositif (2) et la deuxième borne (202) du dispositif étant en outre configurée pour être connectée à une anode dudit autre thyristor (Th2).

3. Dispositif (2 ; 2') selon la revendication 1 ou 2, comprenant en outre un circuit (3) configuré pour fournir le signal de commande à la troisième borne (206) du dispositif (2 ; 2'), le circuit (3) étant connecté à la deuxième borne (202) du dispositif (2 ; 2') et étant configuré pour être alimenté électriquement par un potentiel d'alimentation (Vcc), de préférence positif, référencé à la deuxième borne (202) du dispositif (2 ; 2').

4. Circuit intégré comprenant un dispositif (2 ; 2') selon l'une quelconque des revendications 1 à 3.

5. Pont redresseur (1') comprenant :
une première branche (D1, D5) et une deuxième branche (D2, D6) connectées en parallèle entre un premier noeud interne (112) du pont (1') relié, de préférence connecté, à un premier noeud de sortie (104) du pont (1'), et un deuxième noeud interne (110) du pont (1') ;
une résistance (R) et un thyristor (Th3) connectés en parallèle entre le deuxième noeud interne (110) et un deuxième noeud de sortie (106) du pont (1'), l'anode du thyristor (Th3) étant connectée au deuxième noeud de sortie (106) ; et
un dispositif (2') selon la revendication 1, la deuxième borne (202) du dispositif étant connectée au deuxième noeud de sortie (106) et la première borne (204) du dispositif (2') étant connectée la gâchette de cathode du thyristor (Th3).

6. Pont redresseur (1') selon la revendication 5 comprenant en outre un circuit (3) configuré pour fournir un signal de commande à la troisième borne (206) du dispositif (2'), le circuit (3) étant connecté au deuxième noeud de sortie du pont (1') et étant configuré pour être alimenté électriquement par un potentiel d'alimentation (Vcc), de préférence positif, référencé au deuxième noeud de sortie (106) du pont (1').

7. Pont redresseur (1) comprenant :
un dispositif (2) selon la revendication 2, la deuxième borne (202) du dispositif (2) étant connectée à un premier noeud interne (110) du pont (1) relié, de préférence connecté, à un premier noeud de sortie (106) du pont (1) ;
un premier thyristor (Th1) comprenant une cathode connectée à un premier noeud d'entrée (100) du pont, une anode connectée au premier noeud interne (110), et une gâchette de cathode connectée à la première borne (204) du dispositif (2) ; et
un deuxième thyristor (Th2) comprenant une cathode connectée à un deuxième noeud d'entrée (102) du pont (1), une anode connectée au premier noeud interne (110), et une gâchette de cathode connectée à la quatrième borne (208) du dispositif (2).

8. Pont redresseur selon la revendication 7 comprenant en outre un circuit (3) configuré pour fournir un signal de commande à la troisième borne (206) du dispositif (2), le circuit (3) étant connecté au premier noeud interne (110) du pont (1) et étant configuré pour être alimenté électriquement par un potentiel d'alimentation (Vcc), de préférence positif, référencé au premier noeud interne (110) du pont (1).

9. Pont redresseur (1) selon la revendication 7 ou 8, comprenant en outre :
une diode (D1) comprenant une cathode connectée à un deuxième noeud interne (112) du pont (1) relié, de préférence connecté, à un deuxième noeud de sortie (104) du pont (1), et une anode connectée au premier noeud d'entrée (100) du pont (1) ;
une autre diode (D2) comprenant une cathode connectée au deuxième noeud interne (112) du pont (1) et une anode connectée au deuxième noeud d'entrée (102) du pont (1).

10. Circuit intégré comprenant un pont redresseur (1, 1') selon l'une quelconque des revendications 5 à 9.

11. Contacteur statique (4) comprenant :
un premier thyristor (Th5) et un deuxième thyristor (Th4) connectés en antiparallèle entre une première borne (402) du contacteur (4) et une deuxième borne (400) du contacteur (4), une anode du premier thyristor (Th5) étant connectée à la première borne (402) du contacteur (4) ; et
un dispositif (2') selon la revendication 1, la première borne (204) du dispositif (2') étant connectée à une gâchette de cathode du premier thyristor (Th5) et la deuxième borne (202) du dispositif (2') étant connectée à la première borne (402) du contacteur (4).

12. Contacteur (4) selon la revendication 11 comprenant en outre un circuit (3) configuré pour fournir un signal de commande à la troisième borne (206) du dispositif (2'), le circuit (3) étant connecté à la première borne (402) du contacteur et étant configuré pour être alimenté électriquement par un potentiel d'alimentation (Vcc), de préférence positif, référencé à la première borne (402) du contacteur.

13. Contacteur selon la revendication 12, dans lequel le circuit (3) est en outre configuré pour fournir un autre signal de commande à la gâchette du deuxième thyristor (Th4), de préférence, une borne (301) du circuit (3) configurée pour fournir ledit autre signal de commande étant connectée à la gâchette du deuxième thyristor (Th4) ou étant reliée à la gâchette du deuxième thyristor (Th4) par une diode.

14. Circuit intégré comprenant un contacteur (4) selon l'une quelconque des revendications 11 à 13.

## Patentansprüche

1. Ein Steuergerät (2; 2'), das einen Triac (Tr) und eine erste Diode (D3) aufweist, die in Reihe zwischen einem ersten Anschluss (204) des Geräts (2; 2'), der konfiguriert ist, um mit einem Kathodengate eines Thyristors (Th1; Th3; Th5) und verbunden zu werden, und einem zweiten Anschluss (202) des Geräts (2; 2'), der konfiguriert ist, um mit einer Anode des Thyristors (Th1; Th3; Th5) verbunden zu werden, wobei der Triac (Tr) ein Gate hat, das mit einem dritten Anschluss (206) des Geräts (2; 2') verbunden ist, der konfiguriert ist, um ein Steuersignal zu empfangen, **dadurch gekennzeichnet, dass** die erste Diode (D3) eine Kathode hat, die mit dem ersten Anschluss (204) des Geräts (2; 2') gekoppelt ist.

2. Das Gerät (2) nach Anspruch 1, wobei die Kathode der ersten Diode (D3) mit dem ersten Anschluss (204) des Geräts (2) verbunden ist, wobei das Gerät (2) ferner Folgendes aufweist:
einen vierten Anschluss (208), der konfiguriert ist, um mit einem Kathodengate eines anderen Thyristors (Th2) verbunden zu werden; und
eine zweite Diode (D4), vorzugsweise identisch mit der ersten Diode (D3), die in Reihe mit dem Triac (Tr) zwischen dem zweiten (202) und dem vierten Anschluss (208) des Geräts verbunden ist, wobei die Kathode der zweiten Diode (D4) mit dem vierten Anschluss (208) des Geräts (2) verbunden ist und der zweite Anschluss (202) des Geräts ferner konfiguriert ist, um mit einer Anode des anderen Thyristors (Th2) verbunden zu werden.

3. Das Gerät (2; 2') nach Anspruch 1 oder 2, ferner aufweisend eine Schaltung (3), die konfiguriert ist zum Liefern des Steuersignals an den dritten Anschluss (206) des Geräts (2; 2'), wobei die Schaltung (3) mit dem zweiten Anschluss (202) des Geräts (2; 2') verbunden ist und konfiguriert ist, um elektrisch mit einem Stromversorgungspotential (Vcc) versorgt zu werden, vorzugsweise positiv, bezogen auf den zweiten Anschluss (202) des Geräts (2; 2').

4. Eine integrierte Schaltung, die das Gerät (2; 2') nach einem der Ansprüche 1 bis 3 aufweist.

5. Eine Gleichrichterbrücke (1'), die Folgendes aufweist:
einen ersten Zweig (D1, D5) und einen zweiten Zweig (D2, D6), die parallel zwischen einem ersten internen Knoten (112) der Brücke (1'), der mit einem ersten Ausgangsknoten (104) der Brücke (1') gekoppelt,
vorzugsweise verbunden ist, und einem zweiten internen Knoten (110) der Brücke (1') verbunden sind;
einen Widerstand (R) und einen Thyristor (Th3), die parallel zwischen dem zweiten internen Knoten (110) und einem zweiten Ausgangsknoten (106) der Brücke (1') verbunden sind, wobei die Anode des Thyristors (Th3) mit dem zweiten Ausgangsknoten (106) verbunden ist;
und das Gerät (2') nach Anspruch 1, wobei der zweite Anschluss (202) des Geräts mit dem zweiten Ausgangsknoten (106) verbunden ist und der erste Anschluss (204) des Geräts (2') mit dem Kathodengate des Thyristors (Th3) verbunden ist.

6. Die Gleichrichterbrücke (1') nach Anspruch 5, ferner aufweisend eine Schaltung (3), die konfiguriert ist zum Liefern eines Steuersignals an den dritten Anschluss (206) des Geräts (2'), wobei die Schaltung (3) mit dem zweiten Ausgangsknoten der Brücke (1') verbunden ist und konfiguriert ist, elektrisch mit einem Stromversorgungspotential (Vcc) versorgt zu werden, vorzugsweise positiv, bezogen auf den zweiten Ausgangsknoten (106) der Brücke (1').

7. Eine Gleichrichterbrücke (1), die Folgendes aufweist:
das Gerät (2) nach Anspruch 2, wobei der zweite Anschluss (202) des Geräts (2) mit einem ersten internen Knoten (110) der Brücke (1) verbunden ist, der mit einem ersten Ausgangsknoten (106) der Brücke (1) gekoppelt, vorzugsweise verbunden ist;
einen ersten Thyristor (Th1), der eine Kathode aufweist, die mit einem ersten Eingangsknoten (100) der Brücke verbunden ist, eine Anode, die mit dem ersten internen Knoten (110) verbunden ist, und ein Kathodengate, das mit dem ersten Anschluss (204) des Geräts (2) verbunden ist; und
einen zweiten Thyristor (Th2), der eine Kathode aufweist, die mit einem zweiten Eingangsknoten (102) der Brücke (1) verbunden ist, eine Anode, die mit dem ersten internen Knoten (110) verbunden ist, und ein Kathodengate, das mit dem vierten Anschluss (208) des Geräts (2) verbunden ist.

8. Die Gleichrichterbrücke nach Anspruch 7, die ferner eine Schaltung (3) aufweist, die konfiguriert ist zum Liefern eines Steuersignals an den dritten Anschluss (206) des Geräts (2), wobei die Schaltung (3) mit dem ersten internen Knoten (110) der Brücke (1) verbunden ist und konfiguriert ist, um elektrisch mit einem Versorgungsspannungspotential (Vcc) gespeist zu werden, vorzugsweise positiv, bezogen auf den ersten internen Knoten (110) der Brücke (1).

9. Die Gleichrichterbrücke (1) nach Anspruch 7 oder 8, die ferner Folgendes aufweist:
eine Diode (D1) aufweisend eine Kathode, die mit einem zweiten internen Knoten (112) der Brücke (1) verbunden ist, der mit einem zweiten Ausgangsknoten (104) der Brücke (1) gekoppelt, vorzugsweise verbunden ist, und eine Anode, die mit dem ersten Eingangsknoten (100) der Brücke (1) verbunden ist;
eine weitere Diode (D2) aufweisend eine Kathode, die mit dem zweiten internen Knoten (112) der Brücke (1) verbunden ist, und eine Anode, die mit dem zweiten Eingangsknoten (102) der Brücke (1) verbunden ist.

10. Eine integrierte Schaltung, die die Gleichrichterbrücke (1, 1) nach einem der Ansprüche 5 bis 9 aufweist.

11. Ein Festkörperrelais (4), das Folgendes aufweist:
einen ersten Thyristor (Th5) und einen zweiten Thyristor (Th4), die antiparallel zwischen einem ersten Anschluss (402) des Relais (4) und einem zweiten Anschluss (400) des Relais (4) verbunden sind, wobei eine Anode des ersten Thyristors (Th5) mit dem ersten Anschluss (402) des Relais (4) verbunden ist; und
das Gerät (2') nach Anspruch 1, wobei der erste Anschluss (204) des Geräts (2') mit einem Kathodengate des ersten Thyristors (Th5) verbunden ist und der zweite Anschluss (202) des Geräts (2') mit dem ersten Anschluss (402) des Relais (4) verbunden ist.

12. Das Relais (4) nach Anspruch 11, das ferner eine Schaltung (3) aufweist, die konfiguriert ist zum Liefern eines Steuersignals an den dritten Anschluss (206) des Geräts (2'), wobei die Schaltung (3) mit dem ersten Anschluss (402) des Relais verbunden ist und konfiguriert ist, um mit einem Stromversorgungspotential (Vcc) elektrisch gespeist zu werden, vorzugsweise positiv, bezogen auf den ersten Anschluss (402) des Relais.

13. Das Relais nach Anspruch 12, wobei die Schaltung (3) ferner konfiguriert ist zum Liefern eines weiteren Steuersignals an das Gate des zweiten Thyristors (Th4), vorzugsweise an einen Anschluss (301) der Schaltung (3), die zum Liefern des anderen Steuersignals konfiguriert ist, das mit dem Gate des zweiten Thyristors (Th4) verbunden ist oder über eine Diode mit dem Gate des zweiten Thyristors (Th4) gekoppelt ist.

14. Eine integrierte Schaltung, die das Relais (4) nach einem der Ansprüche 11 bis 13 aufweist.

## Claims

1. A control device (2; 2') comprising a triac (Tr) and a first diode (D3) series-connected between a first terminal (204) of the device (2; 2') configured to be connected to a cathode gate of a thyristor (Th1; Th3; Th5), and a second terminal (202) of the device (2; 2') configured to be connected to an anode of the thyristor (Th1; Th3; Th5), the triac (Tr) having a gate connected to a third terminal (206) of the device (2; 2') configured to receive a control signal, **characterized in that** the first diode (D3) has a cathode coupled to the first terminal (204) of the device (2; 2').

2. The device (2) according to claim 1, wherein the cathode of the first diode (D3) is connected to the first terminal (204) of the device (2), the device (2) further comprising:
a fourth terminal (208) configured to be connected to a cathode gate of another thyristor (Th2); and
a second diode (D4), preferably identical to the first diode (D3), series-connected to the triac (Tr) between the second (202) and fourth (208) terminals of the device, the cathode of the second diode (D4) being connected to the fourth terminal (208) of the device (2) and the second terminal (202) of the device being further configured to be connected to an anode of said other thyristor (Th2).

3. The device (2; 2') according to claim 1 or 2, further comprising a circuit (3) configured to deliver the control signal to the third terminal (206) of the device (2; 2'), the circuit (3) being connected to the second terminal (202) of the device (2; 2') and being configured to be electrically powered with a power supply potential (Vcc), preferably positive, referenced to the second terminal (202) of the device (2; 2').

4. An integrated circuit comprising the device (2; 2') according to any of claims 1 to 3.

5. A rectifying bridge (1') comprising:
a first branch (D1, D5) and a second branch (D2, D6) connected in parallel between a first internal node (112) of the bridge (1') coupled, preferably connected, to a first output node (104) of the bridge (1'), and a second internal node (110) of the bridge (1');
a resistor (R) and a thyristor (Th3) connected in parallel between the second internal node (110) and a second output node (106) of the bridge (1'), the anode of the thyristor (Th3) being connected to the second output node (106); and
the device (2') according to claim 1, the second terminal (202) of the device being connected to the second output node (106) and the first terminal (204) of the device (2') being connected to the cathode gate of the thyristor (Th3).

6. The rectifying bridge (1') according to claim 5, further comprising a circuit (3) configured to deliver a control signal to the third terminal (206) of the device (2'), the circuit (3) being connected to the second output node of the bridge (1') and being configured to be electrically power with a power supply potential (Vcc), preferably positive, referenced to the second output node (106) of the bridge (1').

7. A rectifying bridge (1) comprising:
the device (2) according to claim 2, the second terminal (202) of the device (2) being connected to a first internal node (110) of the bridge (1) coupled, preferably connected, to a first output node (106) of the bridge (1) ;
a first thyristor (Th1) comprising a cathode connected to a first input node (100) of the bridge, an anode connected to the first internal node (110), and a cathode gate connected to the first terminal (204) of the device (2); and
a second thyristor (Th2) comprising a cathode connected to a second input node (102) of the bridge (1), an anode connected to the first internal node (110), and a cathode gate connected to the fourth terminal (208) of the device (2).

8. The rectifying bridge according to claim 7, further comprising a circuit (3) configured to deliver a control signal to the third terminal (206) of the device (2), the circuit (3) being connected to the first internal node (110) of the bridge (1) and being configured to be electrically power with a power supply potential (Vcc), preferably positive, referenced to the first internal node (110) of the bridge (1).

9. The rectifying bridge (1) according to claim 7 or 8, further comprising:
a diode (D1) comprising a cathode connected to a second internal node (112) of the bridge (1) coupled, preferably connected, to a second output node (104) of the bridge (1), and an anode connected to the first input node (100) of the bridge (1);
another diode (D2) comprising a cathode connected to the second internal node (112) of the bridge (1) and an anode connected to the second input node (102) of the bridge (1).

10. An integrated circuit comprising the rectifying bridge (1, 1) according to any of claims 5 to 9.

11. A solid state relay (4) comprising:
a first thyristor (Th5) and a second thyristor (Th4) connected in antiparallel between a first terminal (402) of the relay (4) and a second terminal (400) of the relay (4), an anode of the first thyristor (Th5) being connected to the first terminal (402) of the relay (4); and
the device (2') according to claim 1, the first terminal (204) of the device (2') being connected to a cathode gate of the first thyristor (Th5) and the second terminal (202) of the device (2') being connected to the first terminal (402) of the relay (4).

12. The relay (4) according to claim 11, further comprising a circuit (3) configured to deliver a control signal to the third terminal (206) of the device (2'), the circuit (3) being connected to the first terminal (402) of the relay and being configured to be electrically powered with a power supply potential (Vcc), preferably positive, referenced to the first terminal (402) of the relay.

13. The relay according to claim 12, wherein the circuit (3) is further configured to deliver another control signal to the gate of the second thyristor (Th4), preferably, a terminal (301) of the circuit (3) configured to deliver said other control signal being connected to the gate of the second thyristor (Th4) or being coupled to the gate of the second thyristor (Th4) by a diode.

14. An integrated circuit comprising the relay (4) according to any of claims 11 to 13.
